# EUROPÄISCHE PATENTSCHRIFT

(11) **EP 0 379 972 B1**
(45) Veröffentlichungstag und Bekanntmachung des Hinweises auf die Patenterteilung: **03.03.1993**
(21) Anmeldenummer: 90100989.4
(22) Anmeldetag: 18.01.1990
(51) Int. Cl.: C23C 14/54

(54) **Stromdurchführung an einer Vakuumkammer**
Current passage for a vacuum chamber
Conduction de courant pour une chambre à vide

(30) Priorität: 26.01.1989 CH 245/89
(43) Veröffentlichungstag der Anmeldung: 01.08.1990
(73) Patentinhaber: BALZERS AKTIENGESELLSCHAFT, 9496 Balzers (LI)
(72) Erfinder: Kunz, Anton, FL-9497 Triesenberg (LI)
(74) Vertreter: Scheidegger, Werner & Co.

(56) Entgegenhaltungen:
- CH-A- 5 657 382
- DE-A- 3 504 936

## Beschreibung

Die Erfindung betrifft eine Stromdurchführung an einer Vakuumkammer, die zum Beschichten eines mit einem Stromleiter in Kontakt stehenden Werkstückes dient. Dabei wird auf das in der Vakuumkammer befindliche Werkstück oder Ladegut das in der Vakuumkammer verdampfte Beschichtungsmaterial aufgebracht.

Der Erfindung lag die Aufgabe zugrunde, Massnahmen zu treffen, die sicherstellen, dass das Werkstück nur bei vorhandenem Vakuum in der Kammer mit einem Stromleiter in elektrischem Kontakt steht und dass dieser selbsttätig unterbrochen wird, sobald die Vakuumkammer belüftet wird, um Bedienungsfehler zu vermeiden. Zur Lösung dieser Aufgabe dient eine Stromdurchführung an der Vakuumkammer mit den Merkmalen gemäss Anspruch 1. Der Vorteil der erfindungsgemässen Stromdurchführung besteht darin, dass der Kontakt zwischen Werkstück und Stromleiter sofort unterbrochen ist, sobald die Vakuumkammer belüftet wird, was selbsttätig durch Federkraft erfolgt, und dass umgekehrt auch der elektrische Kontakt wieder hergestellt ist, sobald wieder Vakuum in der Vakuumkammer herrscht.

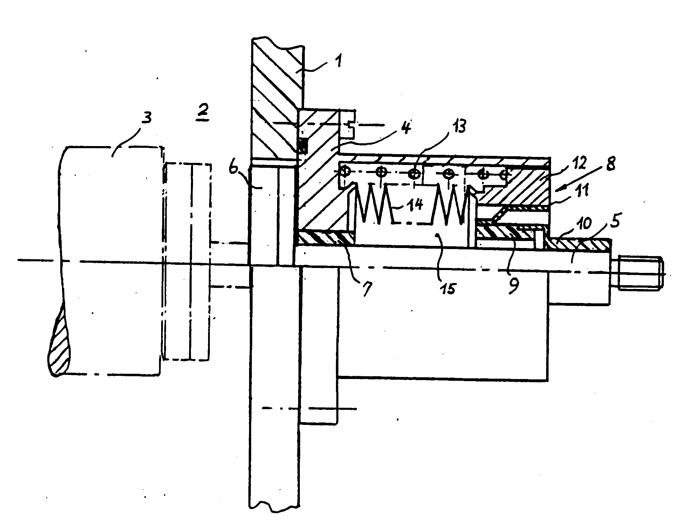

Ein Ausführungsbeispiel der Erfindung wird nachfolgend anhand der einzigen Figur näher erläutert.

Die in der Figur abgebrochen dargestellte Wand 1 der Vakuumkammer umschliesst eine Vakuumkammer 2, in der das strichpunktiert dargestellte und zu beschichtende Werkstück 3 angeordnet ist. An die Vakuumkammerwand 1 ist ein am Ende offener Zylinder 4 vakuumdicht angeflanscht. Durch den Zylinder 4 erstreckt sich koaxial zur Zylinderachse eine Kolbenstange 5, die den Stromleiter bildet, der am rechten Ende mit einer in der Zeichnung nicht dargestellten Stromquelle verbunden ist. Am linken Ende trägt die Kolbenstange 5 eine aus Graphit bestehende Scheibe 6, die zwecks Herstellung des elektrischen Kontakts stirnseitig gegen das Werkstück 3 zur Anlage kommt, wenn der Stromleiter in Form der Kolbenstange 5 in axialer Richtung gegen das Werkstück 3 verschoben wird, welche Stellung in der Figur mit strichpunktierten Linien dargestellt ist. Zu diesem Zweck ist die den Stromleiter bildende Kolbenstange 5 mittels einer aus Isoliermaterial bestehenden Buchse 7 im Boden des Zylinders 4 geführt. Als zweite Führung dient ein ringförmiger Kolben 8, der an der Kolbenstange 5 befestigt ist und im Zylinder 4 geführt ist. Dieser Kolben 8 ist aus einzelnen Teilen zusammengesetzt, wobei eine aus Isoliermaterial bestehende Buchse 9 über einen metallischen buchsenförmigen Körper 10 mit der Kolbenstange 5 in Verbindung steht und ein weiterer buchsenförmiger metallischer Teil 11, der den aus Isoliermaterial bestehenden Teil 9 umschliesst mit einem radial aussenbefindlichen und im Zylinder 4 geführten Teil 12 fest verbunden ist. Gegen diesen Teil 12 des Kolbens 8 liegt innenseitig das Ende einer Schraubendruckfeder 13 an, deren anderes Ende gegen den Boden des Zylinders 4 abgestützt ist. Radial einwärts von dieser Feder 13 ist ein Faltenbalg 14 mit dem einen Ende am Boden des Zylinders 4 und mit dem anderen Ende am ringförmigen Kolben 8 befestigt. Dieser Faltenbalg 14 umschliesst vakuumdicht einen Raum 15, der mit der Vakuumkammer 2 zur Aufnahme des Werkstücks 3 in Verbindung steht. Da die Kolbenstange 5 relativ zum Boden des Zylinders 4 in axialer Richtung beweglich ist und dort keine Abdichtung vorhanden ist, steht über diesem Bereich die Vakuumkammer 2 mit dem Raum 15 in Verbindung, was bedeutet, dass in beiden Räumen der gleiche Druck herrscht.

Gegen die Aussenfläche des ringförmigen Kolbens 8 wirkt der Druck der Atmosphäre und gegen die Kolbeninnenseite wirkt die Kraft der Schraubendruckfeder 13, deren Druckkraft vom gegen die Kolbenaussenseite wirkenden Atmosphärendruck aber überwunden wird, wenn in dem Raum 15 innerhalb des Faltenbalgs 14 auch der in der Vakuumkammer 2 herrschende Unterdruck vorhanden ist. Sowie dieser Unterdruck entsteht, erfolgt eine selbsttätige Axialverschiebung der Kolbenstange 5, sodass die aus Graphit bestehende Scheibe 6 in die strichpunktierte Lage gelangt und der stromleitende Kontakt zum Werkstück 3 hergestellt ist. Die Stromzufuhr ist somit vakuumbetätigt. Wenn dagegen die Vakuumkammer 2 belüftet wird, herrscht auch in dem Raum 15 innerhalb des Faltenbalgs 14 der höhere Druck und die Feder 13 verschiebt dann den ringförmigen Kolben 8 nach rechts, sodass der Stromkontakt unterbrochen wird. Dadurch werden Bedienungsfehler vermieden und ist eine Unfallgefahr durch Strom beseitigt.

## Patentansprüche

1. Stromdurchführung an einer Vakuumkammer, zum Beschichten eines mit einem Stromleiter in Kontakt stehenden Werkstückes (3), dadurch gekennzeichnet, dass der in die Vakuumkammer (2) sich erstreckende, als Kolbenstange (5) ausgebildete Stromleiter im Abstand von der Vakuumkammer einen gegenüber der Kolbenstange (5) isolierten und in einem an der Vakuumkammerwand (1) angeflanschten Zylinder (4) geführten ringförmigen Kolben (8) trägt, dessen Aussenseite unter Atmosphärendruck steht und der mit einem Teil seiner Innenfläche einen mit der Vakuumkammer (2) in Verbindung stehenden und abgedichteten Raum (15) innerhalb des Zylinders (4) begrenzt und ferner durch die Kraft einer dem Atmosphärendruck entgegenwirkenden Feder (13) druckbelastet ist, deren Federkraft bei in dem genannten abgedichteten Raum (15) herrschenden Vakuum kleiner ist als der auf die Kolbenaussenseite wirkende Atmosphärendruck, durch welchen der Kolben (8) in eine Lage verschoben ist, in welcher der als Kolbenstange (5) ausgebildete Stromleiter mit dem Werkstück (3) in stromleitendem Kontakt steht und dass dieser Kontakt bei belüfteter Vakuumkammer (2) durch entgegengesetzte Verschiebung des Kolbens (8) aufgrund des dann in dem abgedichteten Raum (15) herrschenden höheren Drucks und der Federkraft unterbrochen ist.

2. Stromdurchführung nach Anspruch 1, dadurch gekennzeichnet, dass der mit der Vakuumkammer (2) in Verbindung stehende Raum (15) durch einen innerhalb des Zylinders (4) angeordneten, die Kolbenstange (5) im Abstand umschliessenden Faltenbalg (14) abgedichtet ist, dessen eines Ende am Zylinderboden (4) und dessen anderes Ende am ringförmigen Kolben (8) befestigt ist.

3. Stromdurchführung nach Anspruch 1 und 2, dadurch gekennzeichnet, dass die Feder eine innerhalb des Zylinders (4) zwischen dessen Wandung und dem Faltenbalg (14) angeordnete Schraubendruckfeder ist.

## Claims

1. Current passage for a vacuum chamber for coating a workpiece (3) in contact with a current conductor, characterized in that said current conductor extending into the vacuum chamber (2) and having the shape of a piston rod (5) bears at a distance from the vacuum chamber an annular piston (8) electrically insulated from said piston rod (5) and guided in a cylinder (4) flanshed onto the wall (1) of the vacuum chamber, the outer surface of the piston being exposed to atmospheric pressure and a part of its interior surface delimiting a sealed room (15) inside said cylinder (4) communicating with the vacuum chamber (2) and the piston being loaded by the force of a spring (13) acting against atmospheric pressure, the spring force, with the vacuum in said sealed room (15), being smaller than the atmospheric pressure acting on the exterior surface of the piston thereby displacing the piston (8) into a position in which the current conductor in the form of a piston rod (5) is in electrically conductive contact with the workpiece (3), and in that such contact, with the vacuum chamber (2) vented, is interrupted by a displacement in the opposite sense of the piston (8) due to the higher pressure in said sealed room (15) and the force of said spring.

2. Current passage according to claim 1, characterized in that the room (15) communicating with the vacuum chamber (2) is sealed by means of a bellows (14) arranged inside of the cylinder (4) and surrounding at a distance said piston rod (5), one end of the bellows being fixed to the bottom of the cylinder (4) and the other to the annular piston (8).

3. Current passage according to claim 1 and 2, characterized in that the spring comprises a compression helical spring arranged inside the cylinder (4) between its wall and the bellows (14).

## Revendications

1. Conduction de courant pour une chambre à vide servant au revêtement de pièces (3) en contact avec un conducteur de courant, caractérisé en ce que le conducteur de courant s'étendant à l'intérieur de la chambre à vide (2) et ayant la forme d'une tige de piston (5) porte à distance de la chambre à vide un piston annulaire (8) isolé électriquement de la tige de piston (5) et guidé dans un cylindre (4) bridé sur la paroi (1) de la chambre vide, la surface extérieure du piston étant exposée à la pression atmosphérique et une partie de sa surface intérieure délimitant un volume étanchéifié (15) à l'intérieur du cylindre (4) communiquant avec la chambre à vide (2) et le piston étant soumis à l'action d'une force d'un ressort (13) agissant contre la pression atmosphérique, la force du ressort avec le vide régissant dans ledit volume étanchéifié (15) étant plus petite que la pression atmosphérique agissant sur la face extérieure du piston qui déplace le piston (8) dans une position dans laquelle le conducteur de courant sous forme d'une tige de piston (5) est en contact électriquement conductif avec la pièce (3) et en ce que ce contact, avec la chambre à vide (2) aérée, est interrompu grâce à un déplacement dans le sens contraire du piston (8) dû à la force du ressort et à la pression supérieure régissant alors dans ledit volume étanchéifié (15).

2. Conduction de courant selon la revendication 1, caractérisé en ce que le volume (15) communiquant avec la chambre à vide (2) est étanchéifié au moyen d'un soufflet (14) disposé à l'intérieur du cylindre (4) et entourant avec espacement la tige de piston (5), une extrémité du soufflet étant fixée au fond du cylindre (4) et l'autre au piston annulaire (8).

3. Conduction de courant selon la revendication 1 et 2, caractérisé en ce que le ressort est constitué par un ressort de compression cylindrique disposé à l'intérieur du cylindre (4) entre sa paroi et le soufflet (14).
